# EUROPEAN PATENT SPECIFICATION

(11) **EP 0 729 696 B1**
(45) Date of publication and mention of the grant of the patent: **09.02.2000**
(21) Application number: 94901778.4
(22) Date of filing: 02.12.1993
(51) Int. Cl.: H05K 7/18, H05K 7/14, H05K 5/00

(54) **A THREE DIMENSIONAL FRAME CONSTRUCTION AND A USE THEREOF**
DREIDIMENSIONALE RAHMENARTIGE KONSTRUKTION UND DEREN VERWENDUNG
CADRE A TROIS DIMENSIONS ET SON UTILISATION

(30) Priority: 07.12.1992 LK 1046092
(43) Date of publication of application: 04.09.1996
(73) Proprietor: Logstrup, Erik Landsperg, DK-2100 Copenhagen (DK)
(72) Inventor: Logstrup, Erik Landsperg, DK-2100 Copenhagen (DK)
(74) Representative: Lund, Preben
(86) International application number: DK9300401
(87) International publication number: WO9414307

(56) References cited:
- EP-A- 45 926
- WO-A-88/05253
- WO-A-88/07810
- DE-A- 3 024 676
- DE-A- 3 209 771
- DE-C- 3 710 567
- GB-A- 1 512 899

## Description

The invention relates to a three dimensional frame construction connected by screws as defined in the preamble of claim 1.

From DK patent No. 149.875 a frame construction built of corner blocks and frame members is known. The parts are assempled by screws being inserted in bevelled pocked-like recesses in the members, which screws are screwed into bevelled tapped holes in the corner blocks. The corner blocks are manufactured by casting and cutting processing, for example from aluminium or other castable material. The frame members are manufactured by processing of iron or steel plates which during, the processing are bend into profile members at 90° bendings, so that hollow profile members appear which are subsequently finished. Holes, including tapped holes and other holes are configured at suitable places, usually longitudinally placed in rows, so that side plates and doors etc. can be mounted on the outside of the frame construction, and in such a manner that equipment, such as electric, electronic, pneumatic, hydraulic, or other sorts of control equipment can be installed inside the frame contruction, for example with the use of bars, shelves, plates and the like.

For many years this system has been marketed for innumerable applications, however, mainly for construction of so-called plate-enclosed electric installations.

GB-A-1 512 899 discloses three dimensional frame construction comprising the feature cited in the prior art portion of claim 1.

As electric and electronic installations have gradually become less voluminous and have been configured to contain a smaller number of mechanical parts, so that also the weight has been heavily reduced, a demand for a more simple system has arisen, which requires less material and in which the degree of processing the corner blocks and the frame members has been reduced, so that production of the system has become more inexpensive, and assempling can take place in a more simple and more readily manner. Nevertheless, a new system must be sufficiently mechanically stable, even though less materials are used.

The applicant's first draft of an improved three dimensional frame construction is defined in international application No. PCT/LK87/00001 (WO 88/05253) from which it appears that the purpose, among others, is to produce a three dimensional frame construction with a modular dimension of 25 mm, so that the frame construction is more suited for today's smaller and lighter components.

Subsequently the applicant improved the above frame construction as shown in international application No. PCT/LK/87/00002 (WO 88/07810) from which it appears that the corner members longitudinally and with modular distance are provided with threaded pieces inserted in punched holes and in such a manner that the members comprise longitudinal grooves for these threaded pieces.

However, these proposals have a number of drawbacks, as the frame members still require a large degree of processing and consequently become relatively expensive, and yet a corner block construction has not been found which offers the result of simplified assemply and low and competetive price of manufacture.

Furthermore, all the known constructions, including the above mentioned proposals for amended constructions, still are not configured in such a manner that all dimensions in corner blocks and frame members have one and same modular dimenstions.

### Advantages of the invention

A three dimensional frame construction connected by screws according to the invention and with the features defined in the characterizing portion of claim 1 has the advantage that all important dimensions of the corner block as well as the frame members have a modular dimension which permits still more combinations than those of the known constructions and at the same time provides for a rational and competitive production.

At the same time, especially as for the corner block, a construction and form has been achieved which can be produced by casting, in the main almost without any finishing treatment at all. After the casting the only finishing treatment is the cutting of taps in a number of holes. As all holes are at right angles to each other as well as to the sides of the corner block, a rational production with adequate accuracy is achieved at low costs.

All dimensions of importance are configured in modular dimensions so that a very large number of variations and combinations become possible, and so that frame constructions can be built and all important dimensions after the construction still have the same modular dimensions as previously, especially the distance between the tapped holes, which are to be used for subsequent mounting of other parts on the frame construction.

With the frame construction according to the invention a complete modular construction has thus been achieved which construction has the same modular dimensions both with respect to the dimensions as well as to the distance between the mounting holes. Hereby great improvements and simplifications have been obtained.

The process of assempling has been considerably improved in relation to the known constructions, among other things in that one screw is sufficient for the mounting of one frame member to one corner; the screw is at right angles to the the corner block, so that oblique tension will not occur and the screw is placed inside the frame member, so that it will not obstruct the mounting of other parts and so that the frame members on the outside have a plane surface.

By configuring the frame construction according to the invention it is achieved that also the places, i.e. at each end of each frame member where a cross projection is provided in order to mount the member on a corner block, are provided with a mounting hole in the shape of a tapped hole with the same distance from other holes as that of the mounting holes in the middle of the members. Thus the means which are applied for connecting the frame members with the corner blocks are configured in such a manner that no interruptions occur in the row of modularly distanced mounting holes.

By configuring the frame construction according to the invention as defined in the characterizing portion of claim 2 a simplified production is obtained without reducing the strength and in such a manner that processing is minimized.

In order to simplify the assempling of frame members with corner blocks the frame member is preferably configured as defined in the characterizing portion of claim 3. The cuttings are thus configured that the mounting screws as well as the tool to be used in this connection can be inserted in a simple manner.

The corner blocks according to the invention are preferably configured as defined in the characterizing portion of claim 4 in order to obtain a specific and secure assemply.

In addition to the corner blocks and the frame members the frame construction according to the invention may comprise bars as defined in detail in claim 5. It is thus possible to construct any kind of internal division of the frame construction in such a manner that any kind of mounting can take place inside a cubboard or the like built by the frame construction. All parts and holes etc. on the bars are configured with the same modular dimensions as those of the corner blocks and the frame members, so that the parts can by assempled anywhere.

Thus the bar according to the invention has the same advantageous features as the frame member, cf. above.

The frame construction according to the invention is preferably configured with bars as defined in detail in the characterizing portion of claim 6, so that a simple production without reduced strength or reduced combination possibilities is achieved as with the frame members.

The bars of the frame construction are preferably configured with cuttings as defined in the characterizing portion of claim 7 to simplify assemply and any disassemply.

The frame construction according to the invention is configured with modular dimensions as defined in the characterizing portion of claim 8, as thus a construction is achieved which is suited for modern components, and a construction with modular dimensions is achieved which dimensions can be applied for large as well as for small mechanical dimensions.

The frame construction according to the invention is preferably developed to be used for building of a plate-enclosed switch-board or a control device as defined in claim 9.

### The drawing

An example embodiment according to the invention is shown in the drawing and will be described in more detail in the following, where
- fig. 1: shows a corner block seen in a perspective view from the side which in a usual construction constitutes the internal side in a frame construction,
- fig. 2: shows the same as fig. 1, seen from the opposite side, however,
- fig. 3: shows a frame member according to the invention,
- fig. 4: shows a bar according to the invention, and
- fig. 5: shows a corner composed of a corner block and three frame members as well as a bar mounted at a distance from the rectangular corner.

### Description of the example embodiment

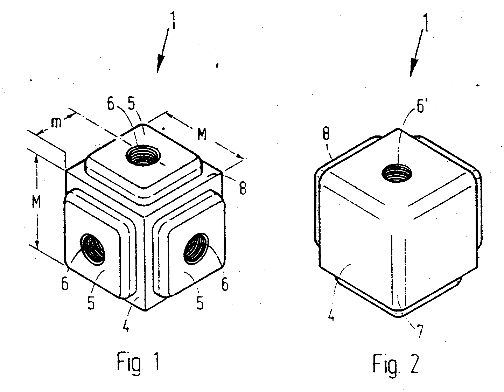

In figs. 1 and 2 is shown a corner block 1 according to the invention. The block consists of a cubic base member 4 which is entirely dice-shaped with the side length M. The three sides shown in fig. 2, which are to be the external sides, may be unbroken, however, as shown, one or more of the surfaces may have a central tapped hole 6' for an 8.0 mm screw. The adjacent external edges 7 are preferably rounded as shown.

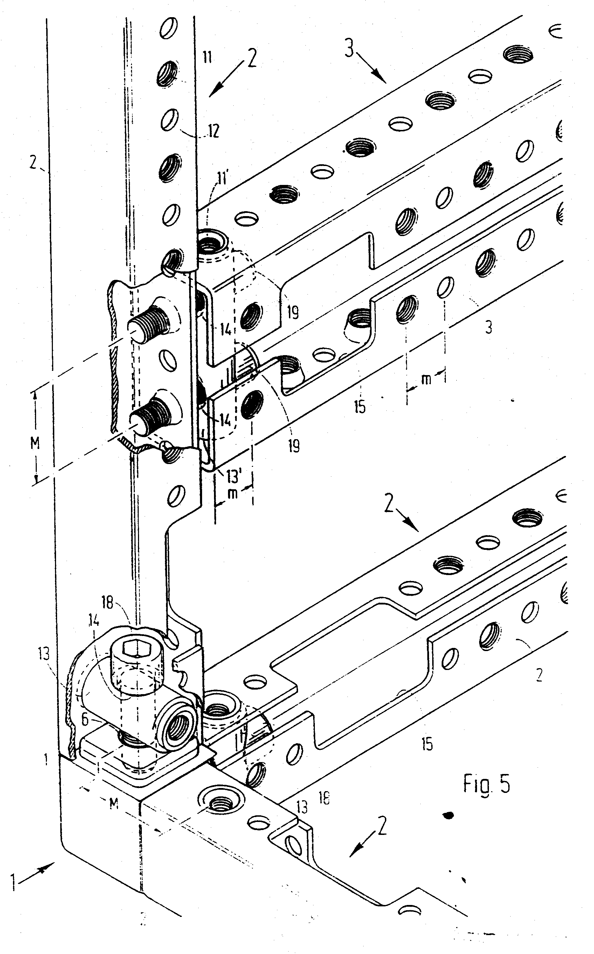

The three other sides which are to be the internal sides of the corner are provided with plug members 5 cast integrally with the base member 4. The plug members are slightly tapered to facilitate engagement with the frame members, as shown in fig. 5. The plug members 5 have smaller dimensions than those of the base member, so that a shoulder 8 occurs around the plug member, which shoulder is arranged to abut on the end surfaces of the frame members. The plug members 5 are placed centrally in such a manner that the outer surfaces of a frame member will always be directly flush with the outer surfaces of the cubic base member 4. In the middle of each of the internal sides and thus in the middle of each plug member a tapped hole 6 for a 8.0 mm screw is provided.

All the tapped holes 6, 6' are configured at right angles to the surface in which the hole is provided, and all tapped holes are thus at right angles to each other and centrally placed, i.e. at the distance m from the edge of the base member.

The modular dimensions are M = 2 m = 25 mm, however, modular dimensions other than 25 mm can of course be applied.

The corner block is manufactured by casting, preferably from aluminium or aluminium alloy or from other castable materials with adequate strength and deformation-resistance. The shoulder 8 has preferably a debth of 2 mm, as the plate material, from which the below mentioned frame members and bars are made, preferably has a plate thickness of 2.0 mm.

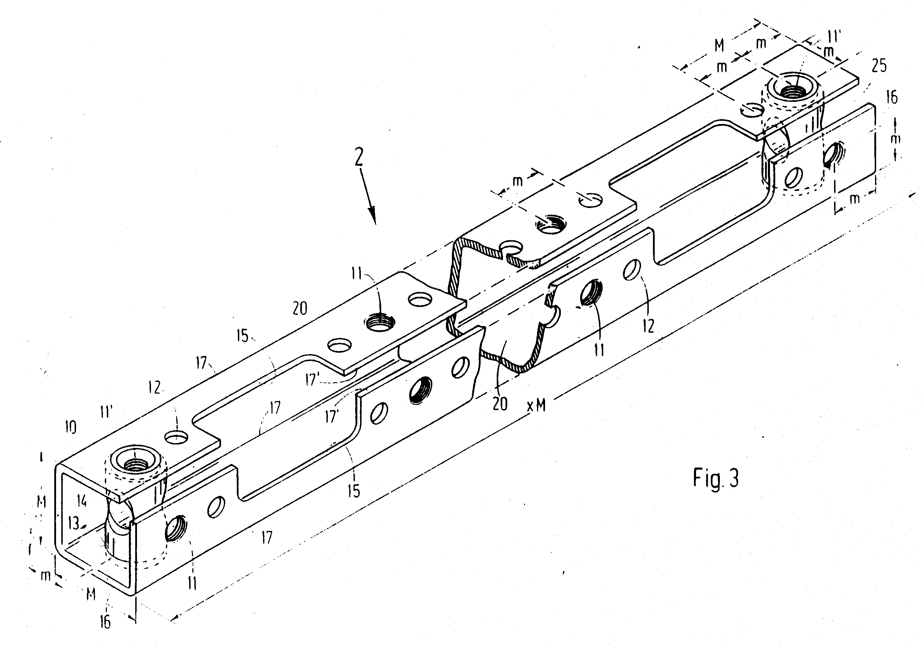

In fig. 3 is shown a frame member 2 according to the invention. The frame members are made in various lengths, all a total multiplum of M, so that frame constructions in any multiplum of M, as to length, width, as well as heigth, can be built. As will be seen from fig. 3 the frame member is produced by bending of steel or iron plate, preferably a plate with a thickness of 2.0 mm. As will be seen from the drawing, the frame member can be made by three 90° bendings 17, so that a profile member with the sides 20 and with a square cross-sectional profile with the side lengths M appears, however, in such a manner that the two adjacent free edges 17' end at a distance from each other, thus leaving out the fourth edge, and producing a through-going longitudinal slit 25. The two sides on each side of the slit 25 each comprises a longitudinal row of holes 11, 11', 12, and in such a manner that a tapped hole 11, 11' for a 6.0 mm screw is always the first hole measured from the end surface 16. Besides, the mounting holes are usually configured in such a manner that every second hole 12 is not tapped. The tapped holes 11 occur by providing a pressing of material which is tapped. From the end surface 16 to the first tapped hole the distance is always m. Likewise, the distance between the holes is m resulting in that the distance between the tapped holes is always M. The holes are placed in a row at the distance m from the nearest rectangular edge 17, so that all the holes are provided in the middle of a side in the square cross-sectional profile. The two opposite sides usually have no holes, but of course holes may be provided in a similar manner if required.

At the ends of the frame members and at the distance m from the end surface 16 a cross projection 13 is provided. The cross projection has a tapped bore 11' in the side facing upwards shown in fig. 3. In the side facing downwards the projection 13 is cylinder-shaped and inserted in a smooth hole in the frame member in such a manner that the downward end portion of the cross projection 13 is on a level with the downward facing surface of the frame member. The cross projection 13 is thus firmly positioned in the frame member and can resist mechanical impacts in the longitudinal direction of the frame member. In the longitudinal direction the cross projection comprises a through-going bore 14 which is not tapped, which bore is adapted to render space for a connecting screw, as shown in fig. 5. The bore 14 is placed in the middle of the frame member, i.e. the centre distance is the distance m from all free sides 20. For insertion of the connection screw as well as for tools to be used in connection herewith cuttings 15 are configured at each end of the frame member 2 and near the cross projection 13. As shown, the cuttings 15 may be configured with a cutting length of 3 m.

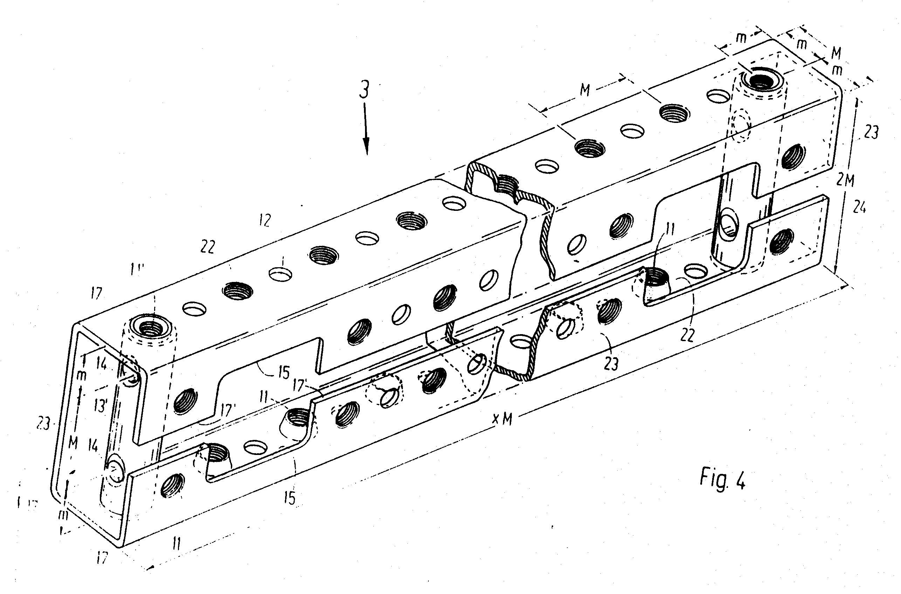

In fig. 4 is shown a bar 3 according to the invention. The bar is substantially configured in a manner corresponding to that of the frame member in fig. 3, however, seen in cross-sectional profile the bar is configured like two cross-sectional profiles of the frame member side by side. Thus the bar is of the outer dimensions: thickness = M, height = 2 M and length = X M. Furthermore, the bars are configured with four rectangular bendings in such a manner that the longitudinal slit 24, corresponding to the slit 25 in fig. 3, occurs in the middle of one of the long sides of the bar. In each end of each bar a cross projection 13' is provided which is fastened in the manner explained in connection with fig. 3, however, the cross projection comprises two holes 14 provided at the spacing M and at the distance m from the outer side of the bar. The bar has preferably rows of tapped holes 11, 11' with intermediate tapped holes on three of the sides as shown on the drawing and in such a manner that only one side has no holes. The cross projections 13' are provided in a manner similar to that of those on the frame member, i.e. at the distance m from the end surface. In order to produce a bar as shown in fig. 2 four rectangular bendings 17 are required, as the bar is preferably made from the same plate material as the frame members. The bars are also produced in various lengths, all a multiplum of M. In cross-sectional profile each bar 3 comprises two short sides 22 and two long sides 23, of which one side comprises the slit 24.

In fig. 5 a corner of a three dimensional frame construction connected by screws according to the invention is shown, where a corner block 1, three frame members 2 and a bar 3 are screwed together. As shown in the drawing and the shown modular dimensions in figs. 1 - 4, it will be possible to perform assemplings and mounting anywhere in such a construction by using the modular dimensions m and M. The connecting bolts 18 are preferably 8.0 mm Allen screws for assemply in the corner block, while the connecting screws 19 for mounting a bar 3 with a frame member are preferably 6.0 mm Allen screws.

## Claims

1. A three dimensional frame construction connected by screws for producing device cabinets etc. of various sizes and comprising frame members (2) arranged to be screwed together by means of corner blocks (1) configured as cubic base members and with tapped holes (6, 6'), which frame members and corner blocks are arranged in such a manner that the frame members together form angles of 90° at a corner block, and that the frame members are configured by bending metal or iron plate workpieces at right angles and so that the frame members have plane sides, of which some are provided with mounting holes (11, 11', 12), and in that the corner blocks and the frame members are configured in modular dimensions M and m, so that M = 2m and
a) that the corner blocks (1) have a base member (4) which is dice-shaped with the edge length M and with centrally placed tapped holes (6, 6') in some of the sides and at right angles and placed at the distance m from the edge,
b) that the corner blocks (1) on some of the sides comprise plug members (5) facing outwards for engagement with a frame member (2),
c) that the frame members (2) have square cross-sectional profile with external dimensions M,
d) that the frame members (2) on some sides comprise tapped holes (11, 11') placed in a row at the distance M and in such a manner that the row of holes is on a line and in the middle of the frame side at the distance m from the edge,
**characterized** in
e) that the first tapped hole in the frame member measured from one of the ends of the frame member is at the distance m from the end surface (16), and
f) that inside each end of the frame member a cross projection (13) is provided at right angles to the longitudinal axis of the frame member comprising a transverse hole (14) positioned radially and congruent with the longitudinal axis of the frame member, where the cross projections are placed at the distance m from the end surface (16) and comprise an axial tapped hole (11').

2. Frame construction according to claim 1, **characterized** in that a frame member comprises three parallel longitudinal 90° bendings (17) and that the fourth corner edge (25) is left out, the frame member comprising two adjacent, plane sides (20) at right angles to each other and without mounting holes as well as, opposite the above sides, two plane sides (21) with mounting holes (11, 11', 12) where the neigbouring edges (17') do not meet in the corner.

3. Frame construction according to claim 1 or 2, **characterized** in that cuttings (15) are configured in the end area of each frame member, which cuttings preferably extend from the oppositely positioned neighbouring edges (17').

4. Frame construction according to claim 1, **characterized** in that the plug members (5) of the corner blocks are configured preferably as a square workpiece integral with the base member (4) and is of such size that one plug member can be inserted in the open end of a frame member whereby the end surface (16) rests against the base member (4) of the corner block.

5. Frame construction according to any of the claims 1 - 4 and further comprising bars (3) with same modular dimensions as the frame members, **characterized** in that the bars have rectangular cross-sectional profile, so that the long sides of the cross-sectional profile have the outer dimensions 2M and the short sides the outer dimensions M, and that each bar internally at each end comprises a cross projection (13) placed at right angles to the opposite short sides of the bar and that two transverse holes (14) are provided in each cross projectioon (13), which transverse holes (14) are positioned parallel to the longitudinal axis of the bar and at a mutual distance M as well as the distance m from the outer surfaces of the bar, where the cross projections are placed at the distance m from the end surface of the bar.

6. Frame construction according to claim 5, **characterized** in that a bar comprises four parallel 90° bendings, so that the bar has four complete longitudinal corner edges, however, in such a manner that a longitudinal and through-going area (24) is left out between adjacent plate edges (17'), and where three of the plane sides (22) of the bar have mounting holes (11, 11', 12) and the fourth plane side (23) has no mounting holes.

7. Frame construction according to claim 5 or 6, **characterized** in that the opposite edges (17') have cuttings (15) at each end of the bar.

8. Frame construction according to any of the claims 1 - 7, **characterized** in that the modular dimensions M = 25 mm and the modular dimensions m = 12.5 mm.

9. Use of the frame construction according to any of the claims 1 - 8 for building a plate-enclosed switch board or a control device for electric material.

## Patentansprüche

1. Eine dreidimensionale mit Schrauben verbundene Rahmenkonstruktion zur Herstellung von Kästen usw. in verschiedener Größe, bestehend aus Rahmenteilen (2), die mit Hilfe von Eckblöcken (1) zusammengeschraubt werden, als kubische Sockelteile mit Gewindelöchern (6,6') bezeichnet, deren Rahmenteile und Endblöcke so zusammengesetzt sind, daß die Rahmenteile zusammen an einem Eckblock 90° Winkel bilden und daß die Rahmenteile durch Biegen von Metall oder Eisenplattenwerkstücken im rechtem Winkel so gestaltet sind, daß die Rahmenteile plane Seiten haben, von denen einige mit Befestigungslöchern (11,11',12) versehen sind und daß die Eckblöcke und Rahmenteile in Modularmaßen M und m festgelegt sind, so daß M = 2m und
a) daß die Eckblöcke (1) ein Sockelteil (4) haben, das würfelförmig ist und eine Kantenlänge M aufweist, in der Mitte einiger Seiten und im rechten Winkel Gewindelöcher (6,6') aufweist, die mit dem Abstand m von der Kante plaziert sind,
b) daß die Eckteile (1) auf manchen Seiten nach außen gerichtete Einsteckteile (5) zur Verbindung mit einem Rahmenteil (2) haben,
c) daß die Rahmenteile (2) einen quadratischen Querschnitt mit den äußeren Maßen M aufweisen,
d) daß die Rahmenteile (2) auf manchen Seiten Gewindelöcher (11,11') aufweisen, die in einer Reihe im Abstand M und so angeordnet sind, daß die Löcher in einer Reihe und in der Mitte der Rahmenseite im Abstand m von der Kante liegen,
**dadurch gekennzeichnet,**
e) daß das erste von einem der Enden des Rahmenteils an gemessene Gewindeloch im Rahmenteil im Abstand m von der Endoberfläche (16) liegt und
f) daß die Innenseite jedes Rahmenteils mit einem Querstück (13) im rechten Winkel zur Längsachse des Rahmenteils versehen ist, das ein abgeschrägtes mit der Längsachse des Rahmenteils radial und deckungsgleich plaziertes Loch (14) aufweist, wo die Querstücke mit dem Abstand m von der Endoberfläche (16) plaziert sind und ein axiales Gewindeloch (11') aufweisen.

2. Rahmenkonstruktion nach Anspruch 1, **dadurch gekennzeichnet**, daß ein Rahmenteil drei parallel längs verlaufende 90° Winkel (17) aufweist und daß die vierte Eckkante (25) ausgelassen ist, das Rahmenteil zwei angrenzende plane Seiten (20) im rechtem Winkel zueinander und ohne Befestigungslöcher aufweist, wie auch zwei plane Seiten (21) gegenüberliegend der oben genannten Seiten mit Befestigungslöchern (11,11',12) und die nebeneinanderliegenden Kanten (17') nicht in der Ecke aufeinander treffen.

3. Rahmenkonstruktion nach Anspruch 1 oder 2, **dadurch gekennzeichnet**, daß sich Einschnitte (15) am Ende jedes Rahmenteils befinden, die vorzugsweise von den gegenüberliegenden Kanten (17') weitergeführt sind.

4. Rahmenkonstruktion nach Anspruch 1, **dadurch gekennzeichnet**, daß die Einsteckteile (5) der Eckteile vorzugsweise als ein quadratisches mit dem Sockelteil verbundenes Werkstück gestaltet und so groß ist, daß ein Einsteckteil in das offene Ende eines Rahmenteils eingesteckt werden kann, wobei die Endoberfläche (16) auf dem Sockelteil (4) des Eckteils ruht.

5. Rahmenkonstruktion nach jedem der Ansprüche 1-4 zusätzlich mit Stangen (3) derselben Modularmaße wie der der Rahmenteile, **dadurch gekennzeichnet**, daß die Stangen rechtwinklige Querschnitte aufweisen, so daß die langen Seiten des Querschnitts die Außenmaße 2M und die kurzen Seiten die Außenmaße M aufweisen und daß jede Stange am inneren Ende ein Querstück (13) im rechten Winkel zu den gegenüberliegenden kurzen Seiten der Stange aufweist und daß sich zwei abgeschrägte Löcher (14) in jedem Querstück (13) befinden, die parallel zu der Längsachse der Stange und mit dem gemeinsamen Abstand M, wie auch dem Abstand m von der äußeren Oberfläche der Stange liegen, wo die Querstücke im Abstand m von der Endoberfläche der Stange plaziert sind.

6. Rahmenkonstruktion nach Anspruch 5, **dadurch gekennzeichnet**, daß eine Stange vier parallel verlaufende 90° Winkel aufweist, so daß die Stange vier ganz längs verlaufende Eckkanten aufweist, die jedoch so gestaltet sind, daß eine längs verlaufende, durchgehende Fläche (24) zwischen angrenzenden Plattenkanten (17') ausgelassen ist und drei der planen Seiten der Stange (22) Befestigungslöcher (11,11',12) aufweisen und die vierte plane Seite (23) keine Befestigungslöcher aufweist.

7. Rahmenkonstruktion nach Anspruch 5 oder 6, **dadurch gekennzeichnet**, daß die gegenüberliegenden Kanten (17') an jedem Ende der Stange Einschnitte (15) aufweisen.

8. Rahmenkonstrukton nach jedem der Ansprüche 1-7, **dadurch gekennzeichnet**, daß Modularmaßen M = 25 mm und Modularmaßen m = 12,5 mm.

9. Verwendung der Rahmenkonstruktion nach jedem der Ansprüche 1-8 zum Bau eines geschlossenen Gehäuses für Schalttafeln oder einer Schalttafel für elektrische Apparaturen.

## Revendications

1. Cadre à trois dimensions relié par des vis pour réaliser des armoires, etc, de tailles variées et comprenant des éléments de cadre (2) disposés de manière à être vissés ensemble au moyen de blocs de coin (1) présentant la forme d'éléments de base cubique et pourvus de trous taraudés (6, 6'), lesdits éléments de cadre et lesdits blocs de coin étant disposés de manière que les éléments de cadre forment ensemble des angles à 90° aux blocs de coin, et de manière que les éléments de cadre soient réalisés par pliage à angle droit de pièces de travail plates en métal ou en fer, et de façon que les éléments de cadre présentent des côtés plan, dont certains sont pourvus de trous de montage (11, 11', 12), et que les blocs de coin et les éléments de cadre soient réalisés dans des dimensions modulaires M et m, de façon que M = 2m et :
a) les blocs de coin (1) présentent un élément de base (4) en forme de dé, avec une longueur d'arête M, et avec des trous taraudés (6, 6') centrés, disposés sur certains des côtés et à angle droit, et disposés à la distance m de l'arête ;
b) les blocs de coin (1) sur certains des côtés comportent des éléments de prise (5) faisant face vers l'extérieur et susceptibles de s'engager avec un élément de cadre (2) ;
c) les éléments de cadre présentent des profils en section droite carrée avec des dimensions extérieures M ;
d) les éléments de cadre (2) sur certains des côtés comportent des trous taraudés (11, 11') placés en alignement à la distance M et de façon que la rangée de trous est disposée sur une ligne et au milieu du côté du cadre à une distance m de l'arête ;
**caractérisé** en ce que
e) le premier trou taraudé dans l'élément de cadre mesuré d'une des extrémités de l'élément de cadre est à une distance m de la surface d'extrémité (16) et
f) à l'intérieur de chaque extrémité de l'élément de cadre, un élément en saillie transversale (13) est disposé à angle droit par rapport à l'axe longitudinal de l'élément cadre, comprenant un trou transversal (14) disposé radialement et en congruence avec l'axe longitudinal de l'élément cadre, tandis que les éléments en saillie transversale sont disposés à la distance m de la surface d'extrémité (16) et comprennent un trou taraudé (11') axial.

2. Cadre selon la revendication 1, **caractérisé** en ce qu'il comporte trois pliages (17) à 90°, parallèles longitudinaux, et en ce que le quatrième hors de coin (25) est absent, l'élément de cadre comprenant deux côtés plan adjacents (20) à angle droit l'un par rapport à l'autre et sans trop de montage, et également opposé au côté du dessus, de côté plan (21) pourvu de trous de montage (11, 11', 12) où les bords voisins (17) ne se rencontrent pas dans le coin.

3. Cadre selon la revendication 1 ou 2, **caractérisé** en ce que des découpes (15) sont réalisées dans la zone d'extrémité de chaque élément cadre, lesdites découpes de préférence s'étendant depuis les bords voisins (17') disposés en regard.

4. Cadre selon la revendication 1, **caractérisé** en ce que les éléments de prise (5) des blocs de coin sont réalisés de préférence sous forme d'un élément carré en une seule pièce avec l'élément de base (4) et de taille telle qu'un élément de prise peut être inséré dans l'extrémité ouverte d'un élément de cadre tandis que la surface d'extrémité (16) repose sur l'élément de base (4) du bloc de coin.

5. Cadre selon l'une des revendications 1 à 4, et comprenant de plus des barres (3) de même dimension modulaire que les éléments de cadre, **caractérisé** en ce que les barres présentent un profilé en section droite rectangulaire de façon que les côtés longs du profilé en section droite présentent des dimensions extérieures 2M et les côtés courts les dimensions extérieures M, et en ce que chaque barre, à chaque extrémité, comporte de manière interne un élément faisant saillie transversalement (13) placé à angle droit par rapport au côté opposé court de la barre, et en ce que deux trous traversants (14) sont disposés dans chaque élément faisant saillie transversalement (13), lesdits trous transversaux (14) étant positionnés parallèlement à l'axe longitudinal de la barre et à une distance mutuelle M et également à une distance m des surfaces extérieures de la barre, tandis que les éléments en saillie transversale sont disposés à une distance m de la surface d'extrémité de la barre.

6. Cadre selon la revendication 5, **caractérisé** en ce qu'une barre comporte quatre pliages à 90°, parallèles, de façon que la barre représente quatre bords de coin longitudinaux et complets, de telle manière cependant qu'une zone longitudinale traversante (24) soit absente entre les bords plan adjacents (17'), et trois des côtés plan (22) de la barre présentant des trous de montage (11, 11', 12), et le quatrième côté plan (23) ne présentant pas le trou de montage.

7. Cadre selon l'une des revendications 5 ou 6, **caractérisé** en ce que les bords opposés (17') présentent des découpes (15) à chaque extrémité de la barre.

8. Cadre selon l'une des revendications 1 à 7, **caractérisé** en ce que les dimensions modulaires M = 25 mm et les dimensions modulaires m = 12,5 mm.

9. Utilisation du cadre selon l'une des revendications 1 à 8 pour réaliser un panneau d'interrupteur à plaque incorporée ou un organe de contrôle pour appareil électrique.
